# FASCICULE DE BREVET EUROPEEN

(11) **EP 1 417 711 B1**
(45) Date de publication et mention de la délivrance du brevet: **05.12.2018**
(21) Numéro de dépôt: 02779602.8
(22) Date de dépôt: 31.07.2002
(51) Int. Cl.: H01L 25/07, H01L 23/49, H01L 23/492, H01L 23/373

(54) **MODULE DE COMPOSANTS ELECTRONIQUES DE PUISSANCE ET PROCEDE D'ASSEMBLAGE D'UN TEL MODULE**
MODUL ELEKTRONISCHER LEISTUNGSBAUELEMENTE UND VERFAHREN ZU DESSEN ZUSAMMENBAU
POWER ELECTRONIC COMPONENT MODULE AND METHOD FOR ASSEMBLING SAME

(30) Priorité: 17.08.2001 FR 0110912
(43) Date de publication de la demande: 12.05.2004
(73) Titulaire: VALEO EQUIPEMENTS ELECTRIQUES MOTEUR, 94017 Créteil Cedex (FR)
(72) Inventeur: THERY, Laurent, F-94120 Fontenay-Sous-Bois (FR); LECOLE, Brice, F-45380 La Chapelle St Mesmin (FR)
(74) Mandataire: Gamonal, Didier
(86) Numéro de dépôt international: PCT/FR2002/002768
(87) Numéro de publication internationale: WO 2003/017368

(56) Documents cités:
- EP-A- 0 791 961
- DE-A- 2 755 404
- US-A- 4 305 088
- PATENT ABSTRACTS OF JAPAN vol. 008, no. 226 (E-272), 17 octobre 1984 (1984-10-17) -& JP 59 108340 A (TOSHIBA KK), 22 juin 1984 (1984-06-22)

## Description

### Domaine de l'invention

La présente invention concerne un module électronique comportant des composants électroniques de puissance ainsi qu'un procédé d'assemblage d'un tel module.

Plus particulièrement, l'invention concerne un module électronique du type comprenant une embase métallique et des composants électroniques montés notamment en pont redresseur sur l'embase.

### Etat de la technique

Selon un agencement connu, les composants électroniques entrant dans la constitution de ce type de module se présentent sous la forme de puces de silicium encapsulées individuellement.

Ce type de technique augmente considérablement l'encombrement du module et rend les composants difficilement interchangeables dans la mesure où chaque fournisseur de composant fournit des composants de configuration spécifique.

Selon un autre agencement connu, qui pallie partiellement ces inconvénients, tous les composants électroniques de puissance du module sont montés sur l'embase. Pour des raisons électriques, certains de ces composants électroniques de puissance du module électronique doivent être électriquement isolés de l'embase. Pour ce faire, on interpose une couche de matière électriquement isolante entre l'embase et ces composants à isoler. De façon connue, cette couche isolante est commune à tous les composants électroniques qui doivent être isolés. Sur certains modules, tous les éléments, y compris ceux devant être connectés à la masse peuvent être isolés.

Dans ce cas, les composants se présentent généralement sous la forme de puces de silicium nues facilement interchangeables.

Cette technique présente néanmoins un inconvénient majeur, dans la mesure où elle présente un coût de revient relativement élevé. En effet l'isolant électrique est coûteux. Cet isolant étant commun à tous les composants de puissance devant être isolé de l'embase, les parties d'isolant situées entre les composants électroniques sont peu efficace pour évacuer les calories dégagées par les composants au cours de leur fonctionnement.

Dans le document DE A 27 55 404, il est décrit un module électronique, comprenant une embase métallique et des composants électroniques de puissance montés sur l'embase. Chaque composant d'une partie des composants est monté sur l'embase avec interposition d'un élément respectif électriquement isolant et conducteur de la chaleur, les autres composants étant raccordés électriquement à ladite embase.

On diminue ainsi considérablement le coût de revient du module dans la mesure où les composants électroniques sont isolés individuellement de l'embase, tout en améliorant l'évacuation des calories dégagées lors du fonctionnement des composants.

Néanmoins un problème se pose car les composant sont emmanchés dans l'embase en sorte que cela ne permet d'optimiser la disposition des composants dans le module et l'interconnexion entre les composants du module n'est pas simple à réaliser.

### Résumé de l'invention

La présente invention a pour objet de palier ces inconvénients de manière simple et économique.

Suivant l'invention le module électronique selon la revendication 1 est du type sus-indiqué et comporte en outre une ceinture périphérique montée sur l'embase, la ceinture intégrant des éléments d'interconnexion en matériaux électriquement conducteurs.

Grâce à l'invention l'interconnexion entre les composants est simple à réaliser et la disposition des composants dans le module est optimisée. En outre la ceinture est simple à réaliser et permet de simplifier l'embase ainsi que l'élément isolant et conducteur de chaleur. De plus les contraintes sur les composants sont diminuées puisque ceux-ci ne sont pas emmancher à force.

L'interconnexion avec des éléments extérieurs au module est également simple à réaliser.

Ainsi dans une forme de réalisation la ceinture périphérique intègre également des éléments d'interconnexion en matériaux électriquement conducteurs afin de réaliser une interconnexion entre les composants du module et des éléments extérieurs à ce dernier.

Dans une forme de réalisation économique la ceinture périphérique est réalisée par moulage d'une matière plastique et des traces métalliques de connexion sont surmoulées dans la ceinture périphérique.

Avantageusement le surmoulage présente des ouvertures dans la ceinture périphérique de manière à réaliser des zones de contact électrique sur ces traces métalliques.

Ce module peut avantageusement être complété par une ou plusieurs des caractéristiques suivantes, prises isolément ou selon toutes les combinaisons techniquement possibles :
- au moins la face de l'élément isolant recevant un composant respectif est revêtue d'une couche métallique.
- la couche métallique placée sur la face de l'élément isolant recevant le composant est raccordée à une borne de raccordement électrique placée au droit de l'embase.
- un support intermédiaire en matériau conducteur de la chaleur et de l'électricité est interposé entre chaque composant de ladite partie de composants et un élément isolant respectif.
- au moins la face de l'élément recevant un composant est raccordée à une borne de raccordement électrique
- les autres composants électroniques sont montés sur l'embase avec interposition d'un support intermédiaire en matériau électriquement conducteur.
- les composants de puissance sont pourvus d'un plot de raccordement monté sur leur face supérieure auquel sont raccordés les conducteurs pour leur raccordement au reste du circuit du module.
- l'élément isolant est constitué d'une plaquette d'alumine.
- chaque face de la plaquette d'alumine est revêtue d'une couche métallique.
- la couche métallique placée sur chaque face de la plaquette d'alumine est en cuivre
- le module comporte en outre une ceinture périphérique et un capot de protection montés sur l'embase et en ce que les composants électroniques sont noyés dans une résine de protection souple.
- le module comporte en outre une ceinture périphérique montée sur l'embase et en ce que les composants sont noyés dans une résine souple revêtue d'une couche de résine rigide de protection.
- les composants électroniques de puissance sont constitués par des puces de silicium nues.

L'invention a également pour objet un procédé d'assemblage selon la revendication 14.

De préférence, postérieurement à la fixation des composants sur l'embase, on fixe sur cette dernière une ceinture périphérique en matériau plastique intégrant des moyens de connexion électrique, et l'on effectue les liaisons électriques nécessaires au sein du module électronique.

En variante ledit élément électriquement isolant est revêtu d'une couche de matériau métallique, qui est fixée par brasage sur l'embase.

En variante également, ledit élément électriquement isolant revêtu d'une couche de matériau électriquement conducteur est fixé par collage sur l'embase.

En variante, ledit élément électriquement isolant revêtu d'une couche de matériau électriquement conducteur est fixé sur l'embase par application d'une pression d'assemblage.

En variante ledit élément électriquement isolant revêtu d'une couche de matériau électriquement conducteur est formé sur l'embase par projection d'un matériau électriquement isolant et conducteur de la chaleur sur l'embase et dépôt sur ce dernier d'une couche de matériau électriquement conducteur.

L'invention est avantageusement applicable à un alternateur de véhicule automobile comportant un pont redresseur, un stator triphasé ou hexaphasé, des phases issues du stator redressées par le pont redresseur, le pont redresseur incluant toutes les caractéristiques du module électronique de puissance selon la revendication 1.

### Brève description des dessins

D'autres buts, caractéristiques et avantages ressortiront de la description suivante, donnée uniquement à titre d'exemple non limitatif, et faite en référence aux dessins annexés sur lesquels :
- la figure 1 est une vue schématique de dessus d'une partie d'un module de composants électroniques de puissance conforme à l'invention ;
- la figure 2 illustre le schéma électronique du circuit réalisé par la portion de module de la figure 1 ;
- la figure 3 illustre schématiquement le montage des diodes négatives du circuit de la figure 2 sur l'embase du module selon un aspect de l'invention ;
- la figure 4 illustre une variante de montage des diodes négatives du circuit de la figure 2 sur l'embase métallique du module selon un aspect de l'invention ;
- la figure 5 illustre schématiquement le montage des diodes positives du circuit de la figure 2 sur l'embase du module selon un aspect de l'invention ;
- la figure 6 est une vue en coupe selon la ligne VI-VI du module de la figure 1, à plus grande échelle ;
- la figure 7 est une vue en coupe d'un module de composant électronique de puissance selon l'invention pourvu d'un capot de protection ;
- la figure 8 est une vue en coupe d'un autre mode de réalisation du module de la figure 7 ; et
- la figure 9 illustre un autre mode de réalisation d'un circuit électronique au moyen d'un module conforme à l'invention.

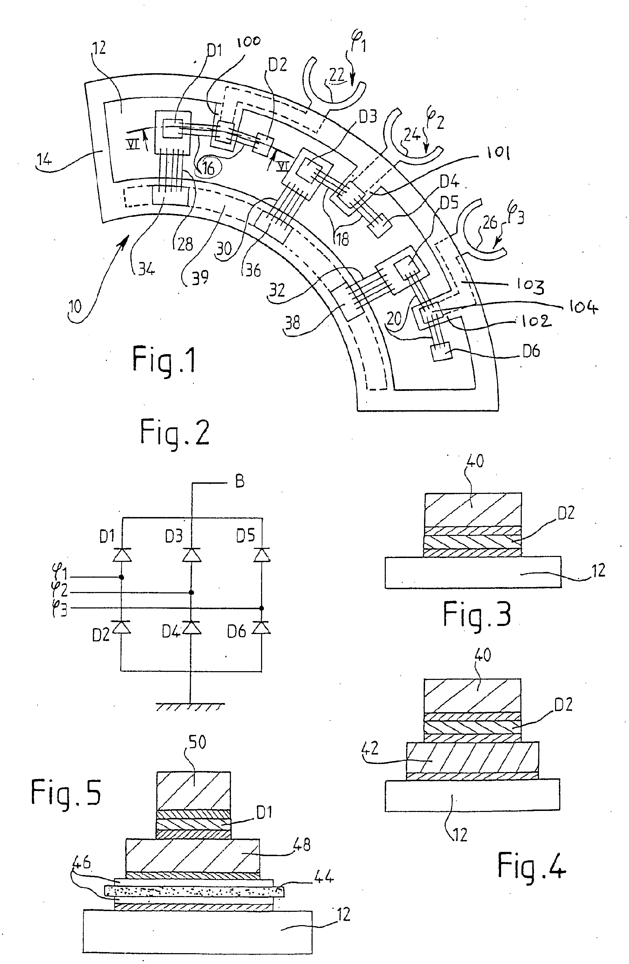

Sur la figure 1, on a représenté une portion d'un module de composants électroniques de puissance conforme à l'invention, désigné par la référence numérique générale 10.

### Description d'exemples de réalisation de l'invention

Le module 10 est essentiellement constitué d'une embase 12 réalisée en un matériau électriquement conducteur approprié pour l'utilisation envisagée, par exemple en cuivre, en aluminium ou en acier, sur la périphérie externe de laquelle est fixée une ceinture 14 périphérique et sur laquelle sont montés des composants électroniques de puissance D1, D2, D3, D4, D5 et D6, sous forme de puces de silicium. La ceinture 14 est avantageusement en matière électriquement isolante et est par exemple réalisée par moulage d'une matière plastique électriquement isolante. Elle intègre des éléments en matériau électriquement conducteur (par exemple en cuivre, laiton) d'interconnexion afin de réaliser une interconnexion entre les composants du module et des éléments extérieurs à ce dernier. Par exemple, cette ceinture est collée sur l'embase. L'intégration des éléments électriquement conducteurs consiste avantageusement à surmouler des traces de connexion métalliques dans la ceinture. On appréciera que l'embase 12 est avantageusement de forme plate et que l'on peut disposer aisément sur celle-ci les composants électroniques de puissance.

La ceinture 14 s'étend à l'intérieur de l'embase 12 formant par exemple trois avancées 100, 101 et 102 contenant respectivement les traces surmoulées 103 des bornes de raccordement 22, 24 et 26. La trace surmoulée 103 présente une zone terminale 104 accessible de l'extérieur pour réaliser la connexion électrique avec des conducteurs 16, 18 et 20.

Comme on le voit sur la figure 2, le circuit électronique réalisé par ces composants est constitué par un pont redresseur triphasé à double alternance.

Ainsi, le circuit est pourvu de trois diodes positives, à savoir les diodes désignées par les références D1, D3 et D5, ainsi que de trois diodes négatives, à savoir les diodes désignées par les références D2, D4 et D6.

Selon ce montage, l'anode des diodes positives D1, D3 et D5 ainsi que la cathode des diodes négatives D2, D4 et D6 sont raccordées, à l'aide des conducteurs 16, 18 et 20, à des moyens de raccordement électrique du module à une source d'alimentation en énergie électrique alternative, constitués des trois bornes de raccordement, respectivement 22, 24 et 26, alimentées respectivement à partir des phases ϕ 1, ϕ 2 et ϕ 3 de la source d'alimentation.

Ces bornes de raccordement 22, 24 et 26 sont intégrés par surmoulage à la ceinture 14, lors du moulage de cette dernière.

Dans l'exemple de réalisation considéré, dans lequel le module est destiné à constituer un module redresseur pour un alternateur de véhicule automobile, les bornes de raccordement 22, 24 et 26 sont connectées aux sorties des phases du stator de l'alternateur. C'est pour cette raison que les bornes présentent des pattes pour la fixation par sertissage des sorties des phases.

Le stator de la machine électrique constituant notamment un alternateur ou un alternateur-démarreur peut être bobiné aussi bien avec des fils qu'avec des barres de conducteur avantageusement conformés en forme d'épingles, que l'on place dans les encoches du stator. Les bobinages ainsi réalisé peuvent être de type triphasé ou hexaphasé. Les conducteurs desdites épingles sont de préférence alignés dans les encoches. Pour plus de précisions, on se reportera à la demande de brevet français N° 01 04770. Avantageusement le module électronique est porté par le palier arrière que comporte de manière connue l'alternateur.

La cathode de chacune des diodes positives D1, D3 et D5 est quant à elle raccordée, au moyen de conducteurs 28, 30 et 32 à des bornes ou plots 34, 36 et 38 de sortie de courant redressé faisant partie d'une piste conductrice 39 intégrée selon l'invention à la ceinture 14 et qui sont localement découverts pour la connexion électrique de ces connecteurs. Comme cela est classique, la piste conductrice 39 est pourvue d'une borne B⁺ (non représentée) sur laquelle vient se brancher la cosse positive de la batterie du véhicule. La borne B⁺ est connectée à la piste conductrice 39 d'une manière connue en soi comme par exemple dans la demande de brevet français FR 00 08836 déposée le 29 juin 2000. La piste 39 consiste ici en une trace métallique surmoulée dans la ceinture. Les traces 39, 103 sont des traces d'interconnexion, la trace réalisant des interconnexion entre les composants.

En se référant maintenant à la figure 3, sur laquelle seule l'une des diodes négatives D2 a été représentée, selon un premier mode d'assemblage, les diodes négatives D2, D4 et D6 sont directement fixées par brasage, ou à l'aide d'une colle électriquement conductrice appropriée, sur l'embase 12, de sorte que leur anode soit électriquement raccordée à cette dernière.

Un plot de raccordement 40 en matériau électriquement conducteur, par exemple en cuivre, est brasé à l'aide d'une colle électriquement conductrice, sur la face supérieure de chaque diode négative, c'est à dire sur leur cathode.

De préférence, on utilise le même matériau pour le montage des plots de raccordement 40 sur ces diodes que pour le montage de ces dernières sur l'embase 12.

De préférence, les plots 40 sont réalisés en un matériau bon conducteur de la chaleur et disposant d'une capacité calorifique élevée, par exemple en cuivre, de manière à permettre un stockage et une évacuation de la chaleur dégagée par les diodes au cours du fonctionnement de ces dernières en cas d'élévation brusque de la tension à leur borne.

En variante, comme visible sur la figure 4, dans le cas où les matériaux constitutifs des diodes négatives et de l'embase 12 présentent des coefficients de dilatation différents, on interpose entre ces dernières un élément de support 42 intermédiaire, par exemple en cuivre, afin de réduire les contraintes mécaniques imposées aux puces des diodes négatives, en particulier dans le cas où l'embase 12 est réalisée en aluminium.

En ce qui concerne les diodes positives D1, D3 et D5, en référence à la figure 5 sur laquelle seule la diode D1 a été représentée, chacune de ces diodes est fixée sur l'embase 12 avec interposition d'un élément 44 respectif électriquement isolant et conducteur de la chaleur constitué par une plaquette.

Comme on le conçoit, les composants peuvent être montés sur une unique plaquette ou être montés sur des plaquettes respectives.

Par exemple, cette couche 44 est réalisée en alumine. Elle est recouverte sur au moins l'une de ses grandes faces mutuellement opposées d'une couche métallique 46 électriquement conductrice, par exemple en cuivre.

La couche 44 en alumine peut être brasée ou collée sur l'embase. Dans le cas d'une fixation par brasure, la couche métallique conductrice 46 est nécessaire car on ne peut pas braser directement l'alumine.

Cependant, toute autre technique appropriée peut être utilisée pour le dépôt d'une telle couche sur l'embase. On peut ainsi la fixer par exemple par collage au moyen d'une colle électriquement conductrice ou isolante, par application d'une pression d'assemblage sur cette plaquette, ou par projection d'alumine, par exemple par plasma sur l'embase, et la recouvrir ensuite d'une couche de cuivre.

Un élément de support intermédiaire 48, réalisé en matériau bon conducteur de la chaleur et de l'électricité, par exemple en cuivre, destiné à améliorer la diffusion de la chaleur en régime stationnaire et à assurer la fonction de capacité thermique lorsque la diode est soumise à des pics de tension transitoires est fixée, par collage ou brasage, sur la plaquette 44 revêtue des couches 46 de matériau électriquement conducteur.

Une puce D1 est alors fixée par brasage ou collage, à l'aide d'une colle électriquement conductrice sur le support intermédiaire 48 de sorte qu'elle repose sur cette dernière par sa cathode.

On notera que, dans le cas où les puces positives D1 sont brasées sur le support intermédiaire 48, on utilise de préférence une brasure dont la température de fusion est supérieure à celle utilisée pour le montage de ce support 48 sur la plaquette électriquement isolante.

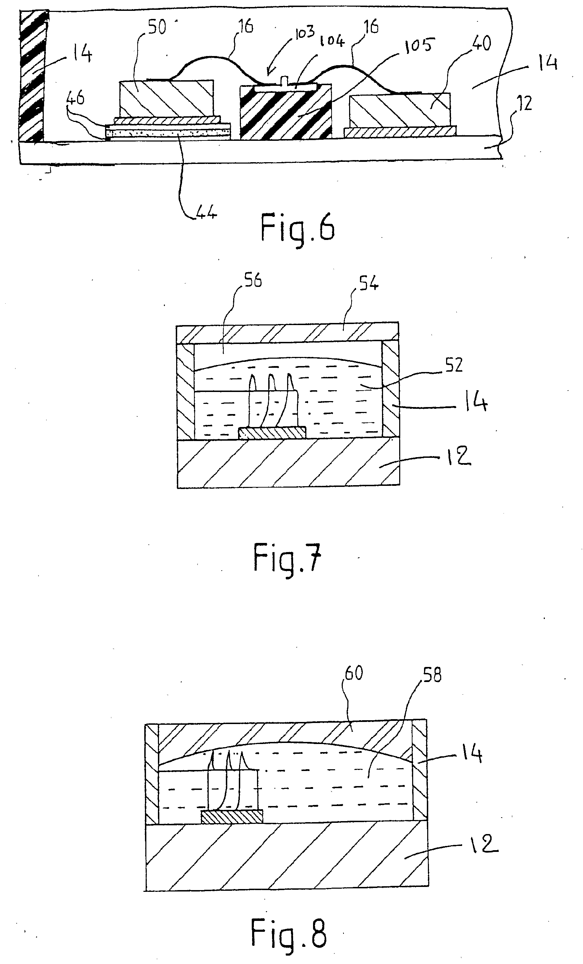

Enfin, comme dans l'exemple de réalisation décrit en référence aux figures 3 et 4, la face supérieure de chaque puce D1 est pourvue d'un plot de raccordement électrique 50 auquel sont raccordés les conducteurs 16, 18 et 20 servant à l'alimentation du pont redresseur (figures 1 et 6).

Après montage des composants sur l'embase, celle-ci est munie d'une ceinture périphérique en matière plastique qui est pourvue des moyens de raccordement électrique.

Ces moyens de raccordement sont ensuite connectés aux plots de raccordement 40 et 50 et aux supports intermédiaires 48 ou la couche métallique 46.

Au niveau de la zone terminale 104 de connexion, les avancées 100, 101 et 102 présentent avantageusement une élévation 105 permettant de réduire la longueur des conducteurs 16, 18 et 20 en positionnant la zone terminale 107 de connexion à la même hauteur que les supports intermédiaires 48 ou les couches métalliques 46. Ainsi, en réduisant la longueur des conducteurs 16, 18 et 20, on augmente la tenue en vibration du module électronique de puissance. Avantageusement, la zone terminale de connexion 107 est équidistante des plots de raccordement 40, 50 des composants de puissance.

En se référant maintenant à la figure 7, le module ainsi réalisé est alors noyé dans une résine 52 souple polymérisable, par exemple un gel de silicone, qui est coulé sur le module de manière à recouvrir l'ensemble des composants électroniques qu'il porte et ainsi que les câblages dont il est pourvu, l'ensemble étant ensuite recouvert d'un capot 54 de protection monté sur l'embase.

Comme on le voit sur cette figure, de préférence, la résine 52 n'emplit pas tout l'espace délimité par le module et le capot 54, de manière à délimiter un volume 56 autorisant une dilatation de la résine 52 au cours du fonctionnement du module.

Selon une variante, représentée sur la figure 8, l'encapsulage du module s'effectue au moyen d'une première résine 58 souple, par exemple identique à la résine utilisée dans le mode de réalisation décrit en référence à la figure 7, dans laquelle sont noyés les composants ainsi que les conducteurs.

Une deuxième résine 60 rigide, par exemple une résine à base d'époxy, est déposée sur la couche de résine souple 58 pour protéger mécaniquement l'ensemble au lieu du capot.

Comme on le conçoit, l'invention qui vient d'être décrite, qui utilise un matériau électriquement isolant et bon conducteur de la chaleur pour le montage d'une partie des composants électronique permet de limiter les coût de réalisation du module électronique, dans la mesure où la quantité de matériau isolant utilisé peut être réduite.

Par ailleurs, le montage selon l'invention permet d'obtenir une bonne évacuation de la chaleur dégagée par les composants au cours de leur fonctionnement.

On notera enfin que le module électronique selon l'invention n'est pas limité aux modes de réalisation décrits ci-dessus mais seulement par les termes des revendications.

En effet, alors que dans les exemples décrits précédemment en référence aux figures 1 à 6, les conducteurs assurant le raccordement de l'anode des diodes positives et de la cathode des diodes négatives aux phases de la source d'alimentation sont connectés au plot supérieur des diodes positives, alors que les conducteurs assurant le raccordement de la cathode de ces diodes aux bornes de sortie de courant sont connectés à la face supérieure conductrice des plaquettes.

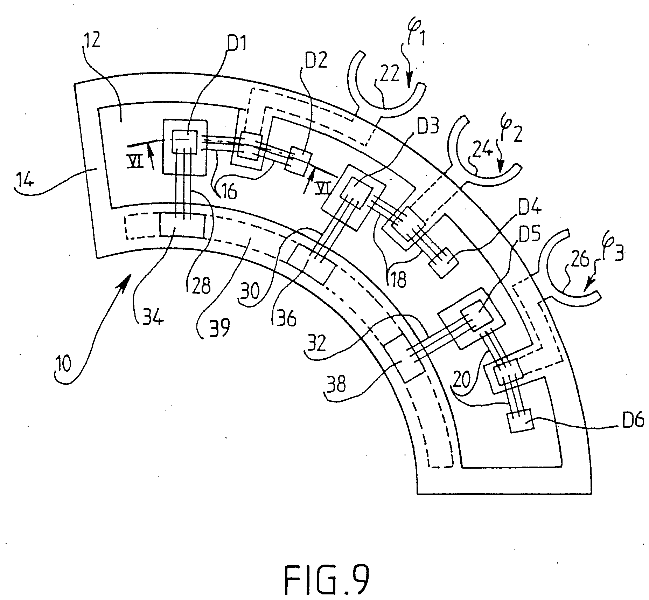

Il est également possible, en variante, comme visible sur la figure 9, de relier les diodes positives aux phases de la source de courant au moyen de conducteurs 16, 18 et 20 connectés à ces dernières, d'une part, et à la face supérieure conductrice de la plaquette 48 ou la couche métallique 46, les conducteurs 28, 30 et 32 de sortie de courant redressé étant quant à eux reliés aux bornes de sortie 34, 36, 38 et au plot supérieur 40, 50 de ces diodes.

Avantageusement, le matériaux isolant électrique et conducteur de chaleur 44 sera pris en sandwich entre deux couches métalliques 46, par exemple en cuivre ou en aluminium de manière à constituer un sous-ensemble ayant un coefficient de dilatation bien adapté pour diminuer les contraintes dans la brasure.

Dans les figures illustrées l'embase et la ceinture délimitent un boîtier à l'intérieur duquel sont montés les composants et dans lequel est coulé la résine 52, 58.

A la figure 7 le capot 54 est monté sur la ceinture. Dans la figure 8 la résine est également montée sur la ceinture. La ceinture, avantageusement en matière électriquement isolante, est un élement de protection des composants

## Revendications

1. Module électronique, comprenant une embase métallique (12) et des composants électroniques de puissance (D1, D2, D3, D4, D5, D6) montés sur l'embase, dans lequel chaque composant d'une première partie des composants est monté sur l'embase avec interposition d'un élément (44) respectif électriquement isolant et conducteur de la chaleur, les composants d'une deuxième partie des composants étant raccordés électriquement à ladite embase, le module électronique comportant en outre une ceinture périphérique (14) formée d'une matière électriquement isolante et montée sur l'embase, la ceinture périphérique (14) intégrant des éléments d'interconnexion en matériaux électriquement conducteurs, lesdits éléments d'interconnexion permettant de réaliser une interconnexion entre les composants du module et des éléments extérieurs à ce dernier, ladite deuxième partie des composants constituant le reste des composants qui ne fait pas partie de ladite première partie.

2. Module selon la revendication 1, **caractérisé en ce qu'**au moins la face de l'élément (44) isolant recevant un composant respectif est revêtue d'une couche métallique (46).

3. Module selon la revendication 2, **caractérisé en ce que** la couche métallique (46) placée sur la face de l'élément (44) isolant recevant le composant est raccordée à une borne de raccordement électrique placée au droit de l'embase, ladite borne de raccordement électrique étant connectée à une piste conductrice (39) intégrée à la ceinture (14).

4. Module selon la revendication 1, **caractérisé en ce qu'**un support intermédiaire (48) en matériau conducteur de la chaleur et de l'électricité est interposé entre chaque composant de ladite première partie de composants et un élément isolant (44) respectif.

5. Module selon la revendication 4, **caractérisé en ce qu'**au moins la face du support intermédiaire (48) recevant un composant est raccordée à un plot (34, 36, 38), ledit plot faisant partie d'une piste conductrice (39) intégrée à la ceinture (14).

6. Module selon la revendication 1, **caractérisé en ce que** les composants électroniques de la deuxième partie des composants électroniques sont montés sur l'embase avec interposition d'un support intermédiaire (42) en matériau électriquement conducteur.

7. Module selon la revendication 1, **caractérisé en ce que** les composants de puissance sont chacun pourvus d'un plot de raccordement (40, 50) monté sur leur face opposée à l'embase auquel sont raccordés des conducteurs d'alimentation (16, 18, 20) pour leur raccordement au reste du circuit du module.

8. Module selon la revendication 1, **caractérisé en ce que** l'élément isolant (44) est constitué d'une plaquette d'alumine et **en ce que** chaque face de la plaquette d'alumine est revêtue d'une couche métallique (46) .

9. Module selon la revendication 1, **caractérisé en ce qu'**il comporte un capot de protection (54) monté sur la ceinture périphérique (14) et **en ce que** les composants électroniques sont noyés dans une résine de protection (52) souple.

10. Module selon la revendication 1, **caractérisé en ce que** les composants sont noyés dans une résine souple (58) revêtue d'une couche de résine rigide (60) de protection.

11. Module selon la revendication 1, **caractérisé en ce que** les composants électroniques de puissance sont constitués par des puces de silicium nues.

12. Module selon la revendication 1, **caractérisé en ce que** la ceinture périphérique (14) est en matière plastique électriquement isolante et **en ce que** les éléments d'interconnexion comprennent des traces métalliques de connexion (103,39) qui sont surmoulées dans la ceinture périphérique (14).

13. Module selon la revendication 12 **caractérisé en ce que** le surmoulage présente des ouvertures dans la ceinture périphérique (14) de manière à réaliser des zones de contact électrique sur ces traces métalliques.

14. Procédé d'assemblage d'un module électronique selon la revendication 1, le procédé comportant les étapes consistant à :
- fixer chaque composant entre un support intermédiaire en matériau bon conducteur de la chaleur et de l'électricité et un plot de raccordement électrique ;
- fixer le support intermédiaire associé à chaque composant de la première partie des composants sur un élément (44) respectif électriquement isolant et conducteur de la chaleur qui est revêtu d'au moins une couche (46) de matériau électriquement conducteur et qui est appliqué sur l'embase, chacun des composants de la première partie étant fixé sur l'embase (12) avec interposition de l' élément (44) électriquement isolant respectif,
- fixer le support intermédiaire associé à chaque composant de la deuxième partie des composants sur l'embase, ces composants étant ainsi raccordés électriquement à l'embase.

15. Procédé selon la revendication 14, **caractérisé en ce que** postérieurement à la fixation des composants sur l'embase, on fixe sur cette dernière la ceinture périphérique intégrant les éléments d'interconnexion électrique, la ceinture périphérique étant en matériau plastique, et l'on relie électriquement aux éléments d'interconnexion électrique de la ceinture, d'une part, le plot de raccordement électrique de chaque composant et et, d'autre part, le support intermédiaire ou la couche électriquement conductrice située sur la face opposée à l'embase dudit élément (44) électriquement isolant associé à chaque composant de la première partie des composants.

16. Procédé selon la revendication 14, **caractérisé en ce que** ledit élément électriquement isolant est revêtu d'une couche de matériau métallique qui est fixé sur l'embase.

17. Procédé selon la revendication 14, **caractérisé en ce que** ledit élément électriquement isolant revêtu d'une couche de matériau électriquement conducteur est formé sur l'embase par projection d'un matériau électriquement isolant et conducteur de la chaleur sur l'embase et dépôt sur ce dernier d'une couche de matériau électriquement conducteur.

18. Alternateur de véhicule automobile comportant un pont redresseur, un stator triphasé ou hexaphasé, des phases issues du stator redressées par le pont redresseur **caractérisé en ce que** le pont redresseur inclut toutes les caractéristiques du module électronique selon l'une des revendications 1 à 13.

## Patentansprüche

1. Elektronisches Modul, das eine Metallbasis (12) und elektronische Leistungskomponenten (D1, D2, D3, D4, D5, D6), die an der Basis montiert ist, umfasst, wobei jede Komponente eines ersten Anteils der Komponenten an der Basis so montiert ist, dass sich dazwischen ein jeweiliges elektrisch isolierendes und wärmeleitendes Element (44) befindet, wobei die Komponenten eines zweiten Anteils von Komponenten mit der Basis elektrisch verbunden sind, wobei das elektronische Modul außerdem eine Umfangseinfassung (14) enthält, die aus einem elektrisch isolierenden Material gebildet und an der Basis montiert ist, wobei die Umfangseinfassung (14) einteilig mit Verbindungselementen aus elektrisch leitenden Materialien ausgebildet ist, wobei die Verbindungselemente ermöglichen, eine Verbindung zwischen den Komponenten des Moduls und Elementen außerhalb dieses Letzteren herzustellen, wobei der zweite Anteil der Komponenten den Rest der Komponenten bildet, der nicht Teil des ersten Anteils ist.

2. Modul nach Anspruch 1, **dadurch gekennzeichnet, dass** wenigstens die Fläche des isolierenden Elements (44), die eine jeweilige Komponente aufnimmt, mit einer Metallschicht (46) beschichtet ist.

3. Modul nach Anspruch 2, **dadurch gekennzeichnet, dass** die Metallschicht (46), die auf der Fläche des isolierenden Elements (44) angeordnet ist, die die Komponente aufnimmt, mit einem elektrischen Verbindungsanschluss verbunden ist, der am Ort der Basis angeordnet ist, wobei der elektrische Verbindungsanschluss mit einer Leiterbahn (39, die in die Einfassung (14) integriert ist, verbunden ist.

4. Modul nach Anspruch 1, **dadurch gekennzeichnet, dass** ein Zwischenträger (48) aus einem Wärme und Elektrizität leitenden Material zwischen jede Komponente des ersten Anteils von Komponenten und ein jeweiliges isolierendes Element (44) eingefügt ist.

5. Modul nach Anspruch 4, **dadurch gekennzeichnet, dass** wenigstens jene Fläche des Zwischenträgers (48), die eine Komponente aufnimmt, mit einer Anschlussfläche (34, 36, 38) verbunden ist, wobei die Anschlussfläche einen Anteil einer Leiterbahn (39) bildet, die in die Einfassung (14) integriert ist.

6. Modul nach Anspruch 1, **dadurch gekennzeichnet, dass** die elektronischen Komponenten des zweiten Anteils elektronischer Komponenten an der Basis unter Einfügung eines Zwischenträgers (42) aus elektrisch leitendem Material montiert sind.

7. Modul nach Anspruch 1, **dadurch gekennzeichnet, dass** die Leistungskomponenten jeweils mit einer Anschlussfläche (40, 50) versehen sind, die auf derjenigen ihrer Flächen montiert ist, die der Basis gegenüberliegt, mit der Versorgungsleiter (16, 18, 20) für ihre Verbindung mit dem Rest der Schaltung des Moduls verbunden sind.

8. Modul nach Anspruch 1, **dadurch gekennzeichnet, dass** das isolierende Element (44) aus einem Aluminiumoxid-Plättchen gebildet ist und dass jede Fläche des Aluminiumoxid-Plättchens mit einer Metallschicht (46) beschichtet ist.

9. Modul nach Anspruch 1, **dadurch gekennzeichnet, dass** es eine Schutzkappe (54) umfasst, die an der Umfangseinfassung (14) montiert ist, und dass die elektronischen Komponenten in ein nachgiebiges Schutzharz eingebettet sind.

10. Modul nach Anspruch 1, **dadurch gekennzeichnet, dass** die Komponenten in ein nachgiebiges Arzt (58) eingebettet sind, das mit einer starren Schutzharzschicht (60) bedeckt ist.

11. Modul nach Anspruch 1, **dadurch gekennzeichnet, dass** die elektronischen Leistungskomponenten durch unbeschichtete Siliziumschips gebildet sind.

12. Moduldach Anspruch 1, **dadurch gekennzeichnet, dass** die Umfangseinfassung (14) aus einem elektrisch isolierenden plastischen Material besteht und dass die Verbindungselemente metallische Verbindungsbahnen (103, 39) umfassen, die in die Umfangseinfassung (14) gegossen sind.

13. Modul nach Anspruch 12, **dadurch gekennzeichnet, dass** der Guss Öffnungen in der Umfangseinfassung (14) aufweist, derart, dass elektrische Kontaktzonen auf diesen metallischen Bahnen verwirklicht sind.

14. Montageverfahren für ein elektronisches Modul nach Anspruch 1, wobei das Verfahren die folgenden Schritte umfasst:
- Befestigen jeder Komponente zwischen einem Zwischenträger aus einem Wärme und Elektrizität gut leitenden Material und einer elektrischen Anschlussfläche;
- Befestigen des Zwischenträgers, der jeder Komponente des ersten Anteils von Komponenten zugeordnet ist, an einem jeweiligen elektrisch isolierenden und wärmeleitenden Element (44), das mit wenigstens einer Schicht (46) aus elektrisch leitendem Material beschichtet ist und das an der Basis angebracht ist, wobei jede der Komponenten des ersten Anteils an der Basis (12) unter Einfügung des jeweiligen elektrisch isolierenden Elements (44) befestigt wird,
- Befestigen des Zwischenträgers, der jeder Komponente des zweiten Anteils von Komponenten zugeordnet ist, an der Basis, womit diese Komponenten mit der Basis elektrisch verbunden sind.

15. Verfahren nach Anspruch 14, **dadurch gekennzeichnet, dass** nach dem Befestigen der Komponenten an der Basis an dieser Letzteren die Umfangseinfassung befestigt wird, mit der die elektrischen Verbindungselemente einteilig ausgebildet sind, wobei die Umfangseinfassung aus einem plastischen Material besteht, und mit den elektrischen Verbindungselementen der Einfassung einerseits die elektrische Anschlussfläche jeder Komponente und andererseits der Zwischenträger elektrisch verbunden wird, wobei sich die elektrisch leitende Schicht auf der Fläche gegenüber der Basis des elektrisch isolierenden Elements (44), das jeder Komponente des ersten Anteils von Komponenten zugeordnet ist, befindet.

16. Verfahren nach Anspruch 14, **dadurch gekennzeichnet, dass** das elektrische isolierende Element mit einer Schicht aus einem Metallmaterial beschichtet ist, die an der Basis befestigt ist.

17. Verfahren nach Anspruch 14, **dadurch gekennzeichnet, dass** das elektrische isolierende Element, das mit einer Schicht aus einem elektrisch leitenden Material beschichtet ist, auf der Basis durch Ausstoßen eines elektrisch isolierenden und wärmeleitenden Materials auf die Basis und durch Ablagern auf dieser Letzteren einer Schicht aus einem elektrisch leitenden Material gebildet wird.

18. Kraftfahrzeuggenerator, der eine Gleichrichterbrücke und einen dreiphasigen oder sechsphasigen Stator umfasst, wobei die von dem Stator ausgehenden Phasen durch die Gleichrichterbrücke gleichgerichtet werden, **dadurch gekennzeichnet, dass** die Gleichrichterbrücke sämtliche Eigenschaften des elektronischen Moduls nach einem der Ansprüche 1 bis 13 aufweist.

## Claims

1. Electronic module, comprising a metal base (12) and power electronics components (D1, D2, D3, D4, D5, D6) mounted on the base, wherein each component of a first portion of the components is mounted on the base with the interposition of a respective electrically insulating and thermally conductive element (44), the components of a second portion of the components being connected electrically to said base, the electronic module furthermore including a peripheral belt (14) formed of an electrically insulating material and mounted on the base, the peripheral belt (14) integrating interconnection elements made of electrically conductive materials, said interconnection elements making it possible to produce an interconnection between the components of the module and elements outside thereof, said second portion of the components forming the rest of the components that do not form part of said first portion.

2. Module according to Claim 1, **characterized in that** at least the face of the insulating element (44) receiving a respective component is covered with a metal layer (46).

3. Module according to Claim 2, **characterized in that** the metal layer (46) situated on the face of the insulating element (44) receiving the component is connected to an electrical connection terminal situated on the right of the base, said electrical connection terminal being connected to a conductive track (39) that is integrated into the belt (14).

4. Module according to Claim 1, **characterized in that** an intermediate support (48) made of thermally conductive and electrically conductive material is interposed between each component of said first portion of components and a respective insulating element (44).

5. Module according to Claim 4, **characterized in that** at least the face of the intermediate support (48) receiving a component is connected to a pad (34, 36, 38), said pad forming part of a conductive track (39) that is integrated into the belt (14).

6. Module according to Claim 1, **characterized in that** the electronic components of the second portion of the electronic components are mounted on the base with the interposition of an intermediate support (42) made of electrically conductive material.

7. Module according to Claim 1, **characterized in that** the power components are each provided with a connection pad (40, 50) that is mounted on their face opposite the base and to which power supply conductors (16, 18, 20) are connected so as to connect them to the rest of the circuit of the module.

8. Module according to Claim 1, **characterized in that** the insulating element (44) is formed of a plate of alumina, and **in that** each face of the plate of alumina is covered with a metal layer (46).

9. Module according to Claim 1, **characterized in that** it includes a protective cover (54) mounted on the peripheral belt (14), and **in that** the electronic components are embedded in a flexible protective resin (52) .

10. Module according to Claim 1, **characterized in that** the components are embedded in a flexible resin (58) covered with a protective rigid resin layer (60).

11. Module according to Claim 1, **characterized in that** the power electronics components are formed by bare silicon chips.

12. Module according to Claim 1, **characterized in that** the peripheral belt (14) is made of electrically insulating plastic, and **in that** the interconnection elements comprise metal connection traces (103, 39) that are overmoulded into the peripheral belt (14).

13. Module according to Claim 12, **characterized in that** the overmoulding has apertures in the peripheral belt (14) so as to create electrical contact zones on these metal traces.

14. Method for assembling an electronic module according to Claim 1, the method including the steps of:
- fixing each component between an intermediate support made of readily thermally and electrically conductive material and an electrical connection pad;
- fixing the intermediate support associated with each component of the first portion of the components to a respective electrically insulating and thermally conductive element (44) that is covered with at least one layer (46) of electrically conductive material and that is applied to the base, each of the components of the first portion being fixed to the base (12) with the interposition of the respective electrically insulating element (44);
- fixing the intermediate support associated with each component of the second portion of the components to the base, these components thus being connected electrically to the base.

15. Method according to Claim 14, **characterized in that**, following the fixing of the components to the base, the peripheral belt integrating the electrical interconnection elements is fixed to said base, the peripheral belt being made of plastic, and, to the electrical interconnection elements of the belt, there is electrically connected the electrical connection pad of each component, on the one hand, and the intermediate support or the electrically conductive layer situated on the face opposite the base of said electrically insulating element (44) associated with each component of the first portion of the components, on the other hand.

16. Method according to Claim 14, **characterized in that** said electrically insulating element is covered with a layer of metal material that is fixed to the base.

17. Method according to Claim 14, **characterized in that** said electrically insulating element covered with a layer of electrically conductive material is formed on the base by projecting an electrically insulating and thermally conductive material onto the base and depositing onto same a layer of electrically conductive material.

18. Motor vehicle alternator including a rectifier bridge, a three-phase or six-phase stator, phases from the stator rectified by the rectifier bridge, **characterized in that** the rectifier bridge includes all of the features of the electronic module according to one of Claims 1 to 13.
